# EUROPEAN PATENT APPLICATION

(11) **EP 4 726 943 A1**
(43) Date of publication of application: **15.04.2026**
(21) Application number: 24206180.2
(22) Date of filing: 11.10.2024
(51) Int. Cl.: H02H 7/122, H02M 1/00, H02M 7/5395

(54) **FREQUENCY CONVERTER, SYSTEM AND METHOD OF DETECTING AN OPERATIONAL DEVIATION AND COMPUTER READABLE MEDIUM**

(71) Applicant: ABB SCHWEIZ AG, 5400 Baden (CH)
(72) Inventor: Peltonen, Lauri, 00380 Helsinki (FI); Bäckström, Filip, 00380 Helsinki (FI); Pieteris, Paulius, 00380 Helsinki (FI)
(74) Representative: Kolster Oy Ab

(57) **Abstract**

The invention relates to a frequency converter, system and method for detecting an operational deviation by monitoring an electric state within an operation controller and/or between the operation controller and an electric machine and wherein the electric state comprises at least a state of current. The frequency converter further comprises at least one processing circuitry configured to: a. define a time window in response to the electric state, and wherein the state of current being configured to be formed over the time window, and the processing circuitry comprises a threshold of an allowable state of current available; and/or b. define a threshold of an allowable state of current in response to the state of current. The frequency converter further comprises a first comparator configured to compare the state of current with the threshold of the allowable state of current. Invention relates also to a computer readable medium.

## Description

### Field

The invention relates to a frequency converter, a system and a method of detecting an operational deviation and computer readable medium.

### Background

Power semiconductor switches are typically utilized in inverters or frequency converters. The state of the power semiconductor switch may be controlled between two operational states: an on-state for conducting current through the switch or an off-state that is a non-conducting state in which current does not flow through the switch. Typical semiconductor switches, such as insulated-gate bipolar transistors (IGBTs) and metal-oxide-semiconductor field-effect transistors (MOSFETs), generally known as solid-state devices, may be used in various power applications. A gate voltage may be utilized with a gate driver to switch the power semiconductor switch on or off.

The semiconductor switches may only tolerate a short-circuit from few to several microseconds, for example, at most 10 µs, without causing permanent damages to the switch. Since the chip sizes are getting smaller and smaller, their tolerance to short-circuit times and/or overcurrent events may become even shorter. In overcurrent events such as in short circuit current, the semiconductor switch needs be turned off (shut down), i.e. to non-conducting state, within a few microseconds for preventing damages. Thus, it is needed to detect overcurrent events, for example, due to the short-circuit event quickly and accurately so as to minimize damages to the switches and/or circuits. In known methods, it may be possible that overcurrent events (e.g. short-circuit) are not detected early enough which may lead the components to damage. A slow reaction may lower the tolerance for the next event. On the other hand, it may also be possible, in known solutions, that overcurrent events are detected incorrectly which may lead to nuisance overcurrent tripping (resulting in erroneous overcurrent detections). Hence, there is a need for a more sophisticated solution to alleviate the issues of the known solution.

### Brief description

The present invention is defined by the subject matter of the independent claims.

Embodiments are defined in the dependent claims.

The embodiments and features, if any, described in this specification that do not fall under the scope of the independent claim are to be interpreted as examples useful for understanding various embodiments of the invention.

### List of drawings

Example embodiments of the present invention are described below, by way of example only, with reference to the accompanying drawings, in which
Figure 1 illustrates an example of an electric machine operation controller system and a frequency converter for detecting an operational deviation which are suitable for carrying out the method of detecting an operational deviation according to embodiments of the invention; and
Figures 2-5 illustrate an example of a method of and frequency converter for detecting an operational deviation according to embodiments of the invention;
Figures 6a, 6b and 6c illustrate an example of wave forms of the state of current and embodiments related to defining a time window and/or threshold of an allowable state of current in response to the state of current;
Figure 7 illustrates an example of a flow diagram of steps of the method according to an embodiment of the invention; and
Figure 8 illustrates examples of signals and wave forms for clarifying embodiments of the invention.

### Description of embodiments

The following embodiments are only examples. Although the specification may refer to "an" embodiment in several locations, this does not necessarily mean that each such reference is to the same embodiment(s), or that the feature only applies to a single embodiment. Single features of different embodiments may also be combined to provide other embodiments. Furthermore, words "comprising" and "including" should be understood as not limiting the described embodiments to consist of only those features that have been mentioned and such embodiments may contain also features/structures that have not been specifically mentioned. All combinations of the embodiments are considered possible if their combination does not lead to structural or logical contradiction.

Semiconductor switches may be utilized, for example in frequency converters, in connection with an electric machine such as an electric motor or an electric generator by a cable. In practice, the cable length or other properties may not be known accurately in advance. However, the length of the cable as well as the diameter and the structure of the cable affect the peaks of electric currents occurring therein. Specifically, when a steep edge of a voltage pulse at one end of the cable is applied, current charges the capacitances of the cable. In case the electric impedance of the load (e.g., motor) at the opposite end of the cable is not equal to the characteristic impedance of the cable, reflection happens at the ends. This results in oscillation of current in the cable. The oscillation attenuates over time, though. In other words, when a steep edge of a voltage pulse is applied to the cable, current in the cable starts to oscillate. During the oscillation, the peaks of current[s] may exceed the overcurrent threshold intermittently and known methods may turn off the switch in such cases even though such may not be necessary. Thus, the known methods may lead to nuisance overcurrent tripping of the semiconductor switch during oscillation. Generally, the period of the oscillation increases with cable length and the period can be several microseconds.

In this document, electric current may be called as current, electric motor may be called as motor, and/or electric generator may be called as generator.

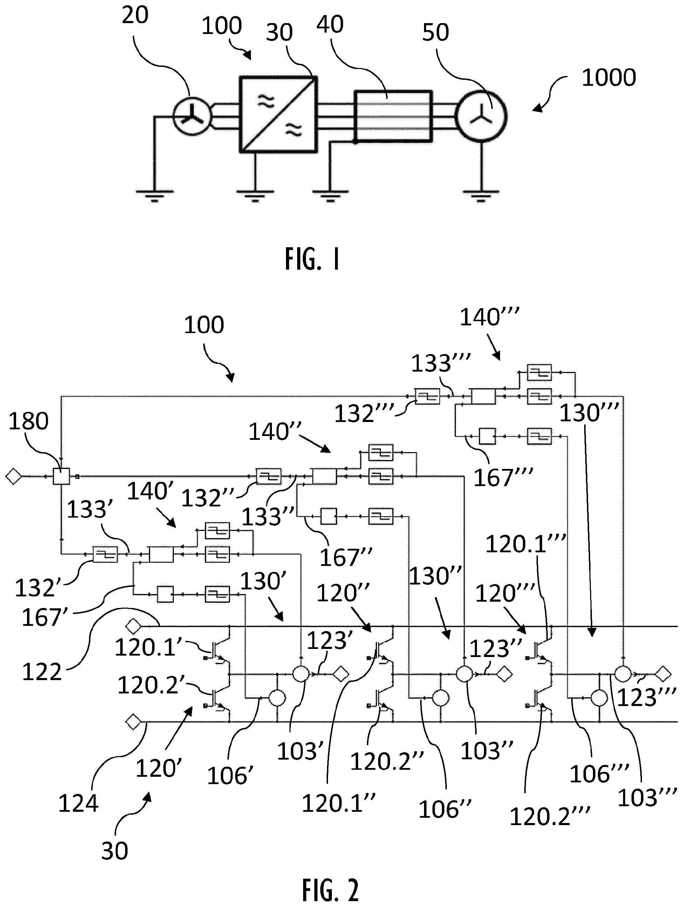

Figure 1 illustrates schematically an electric machine operation controller system 1000 for detecting an operational deviation and a frequency converter 100 comprising an operation controller 30, a cable 40 and an electric machine 50. The cable 40 has a predetermined length and size (cross-section area (mm²)). The cable lengths and cross-sections may depend on the application. For example, the cable length may be hundreds of meters, and the cross-section of the cable may be tens of square millimetres without limiting to these. The operation controller 30 is connected by the cable 40 together electrically with the electric machine 50. Detection of operational deviation from a set-point range may be used to detect an overcurrent event such as a short-circuit event in the system so that preventing measures (preventing components to damage) may be taken at a correct moment. The system 1000 may also comprise an electric power supply 20.

According to an embodiment, the electric machine is a generator. The generator may generate at least single phase current or three-phase current, for example. The detection of operational deviations of the generator is similar to that of an electric motor.

According to an embodiment, the electric machine is a motor. Thus, the Figure 1 illustrates, in other words, according to an embodiment, a motor operation controller system 1000 comprising a frequency converter comprising a motor operation controller 30, a cable 40 and a motor 50. So it is provided a frequency converter 100, a system and a method of detecting an operational deviation therein in which problems related specifically to nuisance overcurrent tripping are mitigated. The operation controller may be configured to control an operation of the motor. For example, the operation controller may control revolutions per minute (rpm) of the motor, i.e., rotational speed of the motor. The motor operation controller system 1000 may also comprise an electric component 20 such as a power supply 20.

According to an embodiment, the electric machine operation controller system 1000 comprises a frequency converter 100 for detecting operational deviation. The frequency converter 100 may be connected with the electric machine 50 by the cable 40. The frequency converter 100 may comprise the operation controller 30. Then the operation controller 30 of the frequency converter 100 may be connected by the cable 40 with the electric machine 50.

According to an embodiment, the electric machine utilizes alternating current. In other words, the motor utilizes alternating current and may be controlled by the alternating current.

According to an embodiment, the electric machine utilizes at least one phase of current. In other words, the motor may be controlled by at least one phase current. The motor may be a three-phase current system that utilizes three phase current. However, the invention applies equally well to systems with various numbers of phases, such as a six-phase system.

According to an embodiment, the operation controller 30 comprises at least one semiconductor component.

According to an embodiment, the operation controller 30 comprises at least one semiconductor switch.

According to an embodiment, the operation controller 30 comprises at least one semiconductor component comprising at least one semiconductor switch.

According to an embodiment, the system 1000 comprises a frequency converter 100. The frequency converter may be formed of comprising a rectifier (AC-DC converter), a DC link and an inverter (DC-AC converter), known, *per se,* by the skilled person.

The operation controller 30 may be arranged in connection with the frequency converter 100. The operation controller 30, according to an embodiment, may form a part of the frequency converter. The operation controller 30 may comprise at least one of a rectifier (AC-DC converter), a DC link and an inverter (DC-AC converter) of the frequency converter. In other words, semiconductor switches of the operation controller 30 may form a part of the frequency converter. Thus, in other words, it may be interpreted that the frequency converter comprising the operation controller 30 may be configured to be connected the electric machine which have the cable connecting them electrically together, for detecting the operational deviation therein.

Thus, the system 1000 may comprise one or more semiconductor components. By controlling input frequency and voltage provided to the electric machine, the operation of the electric machine may be controlled. In case the electric machine is a motor, the frequency converter may control a rotational speed of the motor. Therefore, the operation controller system 1000 may be called as a frequency converter system. The frequency converter may be operated with a pulse width modulation with high voltage rise and fall times. Figure 1 illustrates schematically a three-phase system. Thus, the motor may be, for example, an alternating current (AC) motor such as a three-phase induction motor. In general, the load of the frequency converter may be any electro-mechanical conversion device or machine appropriate for specific applications. In three-phase systems, phases may have a 120 degrees phase shift with each other. A first cable refers with a first phase of electric connection between the operation controller and the electric machine, a second cable refers to a second phase of electric connection between the operation controller and the electric machine and a third cable refers to a third phase of electric connection between the operation controller and the electric machine.

Referring to Figures 2-5, 6a, 6b, 6c, 7 and 8 illustrating embodiments of the method of and frequency converter for detecting an operational deviation. Same reference numbers are used throughout the figures.

According to an embodiment, the frequency converter 100 comprising an operation controller 30 is connected electrically via a cable 40 together with an electric machine 50, for detecting an operational deviation therein. The frequency converter 100 comprises a monitoring circuitry 130', 130", 130‴ monitoring an electric state within the operation controller 30 and/or between the operation controller 30 and the electric machine 50. The electric state comprises at least a state of current 103', 103", 103‴. The frequency converter 100 further comprises at least one processing circuitry 140', 140", 140‴ that defines a time window in response to the electric state, and wherein the state of current is formed over the time window, and the processing circuitry 140', 140", 140‴ comprises a threshold 110 of an allowable state of current available; and/or defines a threshold 110, 110.1, 110.2 of an allowable state of current in response to the state of current 103', 103", 103‴. The frequency converter 100 further comprises a first comparator 132', 132", 132‴ that compares the state of current 103', 103", 103‴ with the threshold 110 of the allowable state of current. Advantageously, the frequency converter renders it possible to vary the time window and/or the threshold of the allowable state of current so as to detect the operational deviation.

In other words, the frequency converter 100, may be connected by the cable with an electric machine 50 electrically together for detecting an operational deviation related to/formed within the cable 40. A monitoring circuitry 130', 130", 130‴ monitors an electric state within the operation controller 30 and/or between the operation controller 30 and the electric machine 50. The electric state comprises at least a state of current 103', 103", 103‴. The frequency converter 100 further comprises at least one processing circuitry 140', 140", 140‴ that defines a time window in response to the electric state. The state of current is formed over the time window. The processing circuitry 140', 140", 140‴ comprises or has available a threshold 110 of an allowable state of current. The frequency converter 100 further comprises a first comparator 132', 132", 132‴ that compares the state of current 103', 103", 103‴ with the threshold 110 of the allowable state of current.

The frequency converter 100comprising the operation controller 30 may be connected with an electric machine 50 by a cable 40 connecting them electrically together for detecting an operational deviation related to/formed within the cable 40. A monitoring circuitry 130', 130", 130‴ monitors an electric state within the operation controller 30 and/or between the operation controller 30 and the electric machine 50. The electric state comprises at least a state of current 103', 103", 103‴. The frequency converter 100 further comprises at least one processing circuitry 140', 140", 140‴ that defines a threshold 110, 110.1, 110.2 of an allowable state of current in response to the state of current 103', 103", 103‴. The frequency converter 100 further comprises a first comparator 132', 132", 132‴ that compares the state of current 103', 103", 103‴ with the threshold 110 of the allowable state of current.

The operational deviation may be due to an overcurrent event. A reason for such may be short circuit event/s, for example and/or faulty operations of the operation controller. This means that if the operation controller breaks down or misbehaves (without physically breaking down), an operational deviation may be detected. In case the operation controller comprises at least one semiconductor components, such as a switch, it may be possible to detect faulty behaviour of the semiconductor components as well. In this case, one possible operational deviation is when detecting no current (flow) at the output of the switch when the switch is on (conducting state), for example, so indicating a fault in the operation controller. Then an operational deviation may be detected, and countermeasures may be taken.

The operational deviation may be detected if, for example, the state of current exceeds the threshold of the allowable state of current, for example, during the time window.

It should be understood that for the term "threshold" it is possible to mean only one value and/or a range. The threshold may comprise a lower limit and an upper limit. It is possible that there is a positive threshold of the allowable state of current and/or a negative threshold of the allowable state of current. In other words, the threshold may be positive and/or negative. It may be possible that when absolute values are compared with the threshold, the threshold may be positive. The threshold may comprise a lower limit range and an upper limit range. The threshold of the allowable state of current may refer to on what is the highest level of electric current that components may tolerate. The threshold of the allowable state of current may refer to what is the highest current, the semiconductor switches may tolerate. In other words, threshold may define a maximum allowable electric current (or maximum allowable electric power). The threshold of the allowable state of current may be defined by the manufacturer of the semiconductor switch. The threshold may be in determined relation to the toleration level of semiconductor switches or allowable state of current defined by the manufacturer. In practice, the threshold of the allowable state of current may depend on cable length and size, drive power and/or application. The threshold level may be as low as possible to reduce the stress on the solid-state devices during actual overcurrent events and avoid nuisance trippings interrupting critical processes.

The term "available" in phrase "a threshold 110 of an allowable state of current available" may mean that the threshold may be a preset value and/or predefined value which may be readily available for use.

Operational deviation may refer to an operation that deviates from a normal operation of the system. Operational deviation may refer to deviation from an operation (electric power) range of the electric machine. Term "overcurrent" may refer to a case in which the energy per time unit increases over the desired limit of electric components and/or system that may break the electric components. In other words, in overcurrent events the energy levels (dissipated power) may increase so high that electric components may break down. Overcurrent event may refer to an exceedance of an operation (electric power) range of the electric machine. In overcurrent events, current value increases over a desired limit. The desired limit may be defined by the manufacturer. In other words, an energy density (current, voltage and/or power) within the operation controller, cable and/or electric machine is exceeding the desired limit. In overcurrent event, the current may exceed an operation range of the electric machine.

According to an embodiment, the time window comprises a first time window and a second time window. The first time window may be temporally narrower than the second time window. The first time window may be a preset initial time window value. For example, the first time window may be about 1 µs and the second time window may be about 4 µs. The preset initial time window may be about 1 µs, for example.

According to an embodiment, the state of current comprises at least one of the following alternating current monitored within the operation controller and/or between the operation controller and the electric machine or polarity of current within the operation controller and/or between the operation controller and the electric machine.

The frequency converter 100 may be configured to monitor a state within the operation controller 30. On the other hand, the frequency converter 100 and the operation controller 30 may form a part of an entity.

Examine Figure 2 more in detail. Figure 2 illustrates an operational controller 30 comprising a 3-phase, 2-level inverter which is an exemplary part of a frequency converter 100 according to an embodiment of the invention. As can be seen components referring to a first phase may be denoted with reference numbers having one ' symbol, a second phase may be denoted with reference numbers having two " symbols, and a third phase may be denoted with reference numbers having three ‴ symbols. The number of phases and/or levels may vary depending on the application.

In other words, the operational controller 30 may form a part of a frequency converter 100 that may comprise a 3-phase, 2-level inverter. Specifically, an inverter side of the frequency converter 100 is at least partly illustrated in Figure 2. In other words, the operational controller 30 may comprise at least an inverter of the frequency converter. A first potential level 122 may be a positive direct current (DC) potential, and a second potential level 124 may be a negative direct current (DC) potential. Figure 2 illustrates schematically that in each phase, two semiconductor switches 120.1', 120.2', 120.1", 120.2", 120.1‴, 120.2‴, e.g. IGBTs, are arranged in series for forming a transistor pair. In one phase, one level comprises one semiconductor switch illustrated in Figure 2. There are three transistor pairs arranged in parallel, in the sense that the half bridges are connected to the same positive and negative DC potentials, according to an embodiment. However, the middle points (which are the outputs) are not connected together, but rather the middle point of each half bridge may provide the individual phase output. In other words, two semiconductor switches are arranged in series and there are three pairs of two semiconductor switches arranged in parallel. Switches in the same transistor pair should not simultaneously be on (conduct). In practice, number of phases as well as levels may vary depending on the application.

According to an embodiment, the operation controller 30 comprises at least one phase system which one phase system comprises a pair 120', 120", 120‴ of semiconductor switches 120.1', 120.2', 120.1", 120.2", 120.1‴, 120.2‴ in which two semiconductor switches 120.1', 120.2', 120.1", 120.2", 120.1‴, 120.2‴ are arranged in series in the at least one phase.

According to an embodiment, the operation controller 30 comprises multiple phase systems formed of semiconductor switches. Each phase system may be formed of semiconductor switches. In other words, one phase system may comprise two semiconductor switches 120.1', 120.2', 120.1", 120.2", 120.1‴, 120.2‴ which are arranged in series. Each phase system may have a certain phase. The multiple phase systems may comprise a first phase system, a second phase system and a third phase system. The first phase system may have a first phase, the second phase system may have a second phase and the third phase system may have a third phase. Phases may have a deterministic phase shift with respect to each other. The deterministic phase shift may be a constant phase shift. In three-phase systems, the phase shift may be, for example, 120 degrees.

According to an embodiment, the pair 120', 120", 120‴ of semiconductor switches 120.1', 120.2', 120.1", 120.2", 120.1‴, 120.2‴ comprises a first semiconductor switch 120.1', 120.1", 120.1‴ and a second semiconductor switch 120.2', 120.2", 120.2‴.

According to an embodiment, each phase comprises the monitoring circuitry 130', 130", 130‴ for monitoring at least one output current value 103', 103", 103‴ of the at least one power semiconductor switch 120', 120", 120‴, 120.1', 120.2', 120.1", 120.2", 120.1‴, 120.2‴.

Examine now an operation of the pair the semiconductor switch 120.1', and 120.2' or 120.1" and 120.2" or 120.1‴ and 120.2‴. In other words, the pair of semiconductor switch may comprise a first semiconductor switch 120.1' arranged at a first level of the phase and a second semiconductor switch 120.2' at a second level of the phase. In practice in the pair, two semiconductor switches are not in conducting state (i.e., on) at the same time, but they will be switching the states between on (conducting) and off (non-conducting) states. In order to ensure that both switches are not on at the same time, there may be a forced commutation delay also known as a blanking time or dead time. This means that after switching off one of the switches, there is a time delay, before the second switch is turned on. In other words, the forced commutation delay makes sure that one of the switches has enough time to actually turn off before the other one is turned on. Information on the commutation delay may be taken into account for defining the time window and/or the threshold of the allowable state of current. In case there is no direct measurement of the output state (voltage), then control and forced commutation delay information may be used to artificially construct the state signal and use that to determine when the time window and/or threshold need to be changed.

So, according to an embodiment, the electric state comprises information on a commutation delay in control of switching at least two semiconductor components. The two semiconductor components may be semiconductor switches.

Since the first semiconductor switch 120.1' is connected to the first potential level 122 such as a positive direct current (DC) potential and the second semiconductor switch 120.2' second potential level 124 may be a negative direct current (DC) potential, according to an embodiment, by switching on and off the switches, it is possible to control current value fed into the electric machine such as a motor. Such a control may be called as a pulse control as pulses are guided from the switches to the electric machine. From the pulses it is formed an averaged signal that is used to operate the electric machine. Typical switching frequencies used in industry may vary from about 1 kHz to about 20kHz. Pulse patterns for control, to produce the desired average voltage, may be formed with, for example, space vector modulation or some other pulse width modulation generation method, or other modulation method.

In Figure 2, it is illustrated a connection line 123', 123", 123‴ which may be connected with the electric machine, for example, via a cable with the motor. So, for example, when the first semiconductor switch 120.1' is on (i.e., conducting) and the second semiconductor switch 120.2' is off (i.e., non-conducting), the electricity flows via the first semiconductor switch 120.1' and via line 123' (and the cable 40). When, on the other hand, the first semiconductor switch 120.1' is off (non-conducting) and the second semiconductor switch 120.2' is on (conducting), the electricity flows via the second semiconductor switch 120.2' and via the connection line 123' (and the cable 40). In other words, the connection lines 123', 123", 123‴ may be connected via the cable 40 with the motor 50. It should be noted that the connection lines 123', 123", 123‴ and the cable 40 may comprises other components which are not, however, described here in detail. When there are changes in the pulses (state changes) that operate the electric machine, there may occur temporary events (i.e. during oscillation) in which current exceeds the threshold, but according to an embodiment, these may not shut down the switches (i.e. there will be no nuisance tripping). Switching of the semiconductor switches to on/off, *per se,* may be controlled via a gate driver as known by the skilled person.

Referring still to Figure 2, for example, when the first semiconductor switch 120.1' is on (i.e., conducting) and the second semiconductor switch 120.2' is off (i.e., non-conducting), the electricity may flow via the first semiconductor switch 120.1' via line 123' (and the cable 40) to the electric machine. When, on the other hand, the first semiconductor switch 120.1' is off (non-conducting) and the second semiconductor switch 120.2' is on (conducting), the electricity may flow via the second semiconductor switch 120.2' via the connection line 123' (and the cable 40) from the electric machine. In other words, the first semiconductor switch 120.1' may conduct positive going current, and the second semiconductor switch 120.2' may conduct negative going current.

In this document, the term "positive going current" may refer to direction from the semiconductor switch to the electric machine. In this document, the term "negative going current" may refer to direction from the electric machine to the semiconductor switch.

As illustrated in Figure 2, the monitoring circuitry 130', 130", 130‴ may be configured to monitor the electric state within the operation controller 30 and wherein the electric state comprises at least the state of current 103', 103", 103‴. In this case the state of current 103', 103", 103‴ may be the current at an output of the operation controller 30. So, the state of current 103', 103", 103‴ may be called as an output current. More specifically, the state of current 103', 103", 103‴ may be called as an output current of the semiconductor switch 120', 120", 120‴.

Due to the possibility of having multiple phases in the system, frequency converter and method, it may be possible to call, in this description, the current value as a phase current value or phase output current values or output current, and voltage as a phase voltage or a phase output voltage or output voltage. Furthermore, state of voltage may be called as output voltage state. Output may mean an output from the operation controller. The term "output" here may mean the connection to the electric machine. The term "input" may mean the connection to the supply network, independent of the power flow direction. This document refers to fundamental current which may mean the output current of the operation controller and its main component. In other words, the fundamental current in this case is preferably the desired actual current level. Pulse modulation and/or cable oscillations may add noise on top of this fundamental current. In steady-state, the desired current value is sinusoidal.

The main component of the output current may be obtained by low pass filtering the output current, *per se,* as known by the skilled person.

In case of three phases and when the state of voltage comprises one or more value of voltage from the phase and the state of current comprises one or more value of current, it may be possible to refer voltages (phase voltages) and currents (phase currents) as a first phase voltage 106', a second phase voltage 106" and a third phase voltage 106‴ and a first phase current 103', a second phase current 103" and a third phase current 103‴. It may also be possible to call a first output voltage 106', a second output voltage 106" and a third output voltage 106‴ and a first output current 103', a second output current 103" and a third output current 103‴.

According to an embodiment, the frequency converter 100 is configured to indicate the operational deviation in case the state of current 103', 103", 103‴ exceeds the threshold of the allowable state of current.

According to an embodiment, the frequency converter 100 is configured to indicate the overcurrent event in case the state of current 103', 103", 103‴ exceeds the threshold of the allowable state of current. In other words, in case the state of current 103', 103", 103‴ exceeds the threshold of the allowable state of current, the operational deviation is detected. Thus, detecting the operational deviation may refer to detecting an overcurrent event. The overcurrent event may be a result of short-circuit. The term overcurrent may refer to a deviation from an operation (electric power) range of the electric component such as semiconductor component and/or an electric machine. Advantageously, by the method, frequency converter and/or the system according to embodiments, nuisance overcurrent tripping of the power semiconductor switch is mitigated. Furthermore, it is possible to notice overcurrent events even more accurately and quickly and/or take preventing measures accordingly. In other terms, it is possible to change a time window and/or overcurrent threshold for detecting an overcurrent event. This enables utilization of variable time window and/or variable threshold for detecting operational deviation, for example, detecting overcurrent events.

According to an embodiment, the electric state comprises a state of voltage 106', 106", 106‴ within the operation controller 30 and/or between the operation controller 30 and the electric machine 50 configured to define the time window. The state of voltage may define the time window. In other words, depending on the state of voltage, the time window may be defined. As illustrated in Figure 2, the monitoring circuitry 130', 130", 130‴ may be configured to monitor the state of the voltage within the operation controller 30. The state of voltage 106', 106", 106‴ may comprise voltage. In other words, the monitoring circuitry 130', 130", 130‴ may monitor voltage within the operation controller 30. Voltage may be called as an output voltage of the operation controller 30 in this case. Figure 2 illustrates a voltage measurement and/or monitoring between the second potential level 124 and the connection line 123', 123", 123‴. The connection line 123', 123", 123‴ is connected to the electric machine via the cable 40. However, it may be possible in practice that a voltage measurement and/or monitoring between the first potential level 122 and the connection line 123', 123", 123‴. A voltage measurement or monitoring may be conducted using both voltage measurement and/or monitoring between the first potential level 122 and the connection line 123', 123", 123‴ and/or voltage measurement and/or monitoring between the second potential level 124 and the connection line 123', 123", 123‴. Monitoring the state of voltage may be conducted with a voltage measurement sensor.

According to an embodiment, the monitoring circuitry 130', 130", 130‴ monitors at least one output current value 103', 103", 103‴ from the pairs of the semiconductor switches 120', 120", 120‴. In other words, the at least one output current is monitored from the pairs of the semiconductors switches 120', 120", 120‴. The monitoring event may comprise measurement. This means that from each phase a current measurement may be conducted. Current may be measured with at least one current measurement sensor.

According to an embodiment, each phase comprises the monitoring circuitry 130', 130", 130‴ for monitoring output voltage of the at least one power semiconductor switch 120', 120", 120‴, 120.1', 120.2', 120.1", 120.2", 120.1‴, 120.2‴.

According to an embodiment, each phase comprises the monitoring circuitry 130', 130", 130‴ for monitoring the state of the measured output voltage 106', 106", 106‴ of the at least one power semiconductor switch 120', 120", 120‴, 120.1', 120.2', 120.1", 120.2", 120.1‴, 120.2‴.

According to an embodiment, the measuring circuitry 130', 130", 130‴ measures at least one output voltage 106', 106", 106‴ from the pairs of the semiconductor switches 120', 120", 120‴. In other words, the output voltage 106', 106", 106‴ is monitored from the pairs of the semiconductors switches 120', 120", 120‴. The monitoring event may comprise measurement. This means that from each phase an output voltage measurement may be conducted.

According to an embodiment, the monitoring circuitry 130', 130", 130‴ monitors the state of the output voltage 106', 106", 106‴ from the pairs of the semiconductor switches 120', 120", 120‴. In other words, the state of the output voltage 106', 106", 106‴ is monitored from the pairs of the semiconductors switches 120', 120", 120‴. The monitoring event may comprise measurement. This means that from each phase a state of the output voltage measurement may be conducted.

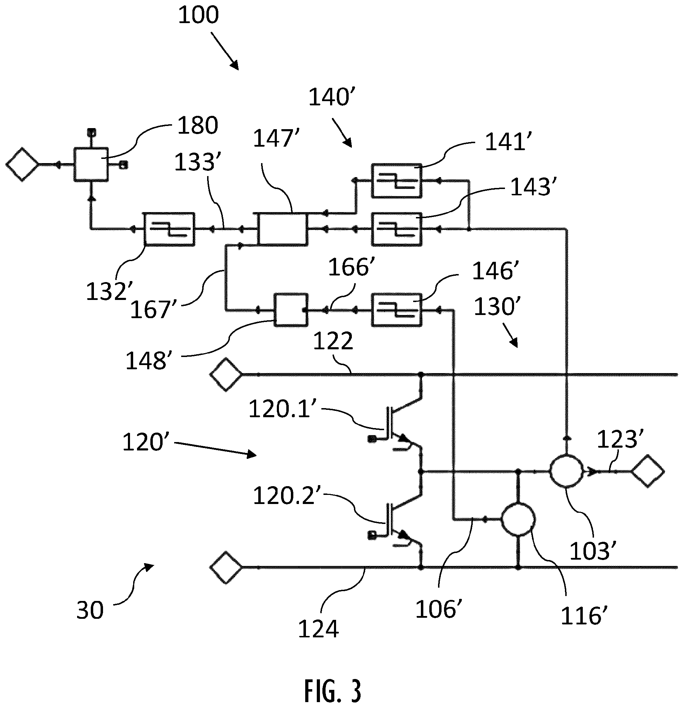

Examine now more in detail about one phase of the operation controller 30, specifically one phase of the 3-phase, 2-level of the inverter, illustrated in detail in Figure 3 according to an embodiment illustrated also in Figure 2. The operation controller 30 may form a part of the frequency controller 100 as illustrated. So, Figure 3 illustrates an inverter of the operation controller comprising a semiconductor component 120'. The semiconductor component 120' may comprise at least two semiconductor switches 120.1', 120.2'. Other phases may have a similar structure as illustrated in Figure 2. In practice, as mentioned above, number of phases, semiconductor components as well as levels may vary depending on the application.

According to an embodiment, the frequency converter 100 comprises means 146' configured to detect a change of the state of voltage from a first state to a second state within the operation controller 30 and/or between the operation controller 30 and the electric machine 50. After detecting the change of the state, the frequency converter 100 changes the time window from a first time window to a second time window for a first time period. The means 146' may detect a change of the state of voltage. The means 146' that detects a change of the state of voltage may be called as a second comparator 146'. The second comparator may compare one or more values.

According to an embodiment, the monitoring circuitry 130' comprises means 116' to monitor the state of voltage of the at least one power semiconductor switch 120'. In other words, the monitoring circuitry 130' may comprise a voltage sensor 116' to measure the voltage 106' of the at least one power semiconductor switch 120' from which the voltage is obtained. The monitored the voltage 106' is compared in a second comparator 146' to a predetermined voltage value. The monitored voltage 106' may be compared to a voltage threshold in the second comparator 146'. In other words, the phase voltage may be compared to a pre-defined voltage threshold to generate a discrete signal providing information of the output state. This information of the output state may be fed to a state machine 148' which handles the time window selection logic. So, the state machine may be configured to define the time window in response to the electric state.

The state of voltage 106' may be voltage within the operation controller 30. Specifically, the state of voltage may be an output voltage of the semiconductor switch 120'. The measured voltage 106' may be compared to a threshold voltage in the second comparator 146'. Monitored voltage 106' may be compared to half of a DC link voltage to provide a signal whether the output voltage is connected to negative 124 or positive DC link potential 122. In other words, half of the DC link refers to voltage in the middle between the first potential level 122 and the second potential level 124. The first potential level 122 may have a positive voltage potential and the second potential level 124 may have a negative voltage potential.

According to an embodiment, an output 166' of the second comparator 146' indicates whether there is a change in the state of voltage. The second comparator 146' may indicate whether there is a change in a voltage level based on which the time window may be defined.

According to an embodiment, in case the change in the state of voltage is indicated, a change in the time window is triggered. In other words, so-called masking time may be increased when the change of the state of voltage is detected, i.e. the time window broadened. Namely, during the change of the state of voltage, it may result in oscillations in current values so that the current values may exceed the threshold. However, in practice these oscillations and exceedances of the threshold may not damage the switches. Thus, by increasing the time window, the overcurrents due to oscillations do not cause switch to trip. In other words, the time window may be understood as a filtering window in which overcurrent values will not trigger overcurrent events. So, the phase voltage may be compared to a pre-defined threshold to generate a discrete signal providing information of the output state.

According to an embodiment, the second comparator output 166' from the second comparator 146' is fed to a state machine 148' which handles the time window selection logic. In other words, the method may comprise a step of feeding the second comparator output 166' of the second comparator 146' to a state machine 148' for handling the time window selection logic. Similarly, the processing circuitry 140' may be configured to feed the second comparator output 166' of the second comparator 146' to a state machine 148' for handling the time window selection logic. The time window 167' may be implemented as the integrator gain, which is an output from the state machine 148'. In other words, the second comparator output 166', i.e. the signal 166', is utilized in the state machine 148' to deduce the state information and based on the state information, the time window may be changed. For example, if a change of the state of voltage is noticed, the state machine 148 feeds information on the state that may change the time window utilized in an operation block 147'.

According to an embodiment, the frequency converter 100 comprises an operation block 147' comprising an integrator configured to integrate the state of current 103'. In other words, the method may comprise a step of integrating the state of current 103', by the integrator 147' over the time window. Therefore, the time window may act as a masking function or as a filtering function. In other words, during the time window, the current values will be gathered during said time window and integrated. This may mean that current values, or in other words state of current, exceeding the threshold of the allowable state of current during the time window may be "blind" for the system. In other words, such exceedances may not cause tripping, i.e., exceedances may not trigger switching off the semiconductor switches.

According to an embodiment, an integrator 147' receives a state information from the state machine 148' and monitored output current 103'.

According to an embodiment, a block 143' comprises the threshold of the allowable state of current, a block comprises a normal operation range 141' and/or a block 147' is an integrator 147'.

In case the threshold of the allowable state of current depicts a limit for overcurrent events, then, the threshold of the allowable state of current, refers to overcurrent threshold. Then, according to an embodiment, a block 143' comprises an overcurrent threshold, a block 141' comprises a normal operation range 141' and/or a block 147' is an integrator 147'.

According to an embodiment, the method comprises a step wherein the state of current 103' is compared to the threshold of the allowable state of current, in block 143', which provides signal 1 for a deviation in operation, 0 otherwise. The value (signal 1 for deviation, for example due to overcurrent event, 0 otherwise) is integrated 147' within the time window (masking time). If current is within normal operation range depicted in block 141', the integrator 147' may be reset to zero.

According to an embodiment, the state of current comprising an output 133' from the integrator 147 is sent to the first comparator 132' for a comparison in which the output 133' is compared with the threshold. From the first comparator 132' a signal is sent to a third comparator unit 180. The third comparator unit 180 may check maximum values from the signals obtained from the first comparators 132', 132", 132‴. Based on the value in the third comparator unit 180, a deviation in operation and/or an overcurrent event may be indicated.

According to an embodiment, a value from the first comparator 132' is sent to a third comparator unit 180. An output from the third comparator unit 180 is used to deduce whether there is an operational deviation, such as an overcurrent event, or not. In other words, based on the value in the third comparator unit 180, a deviation in operation and/or an overcurrent event may be indicated.

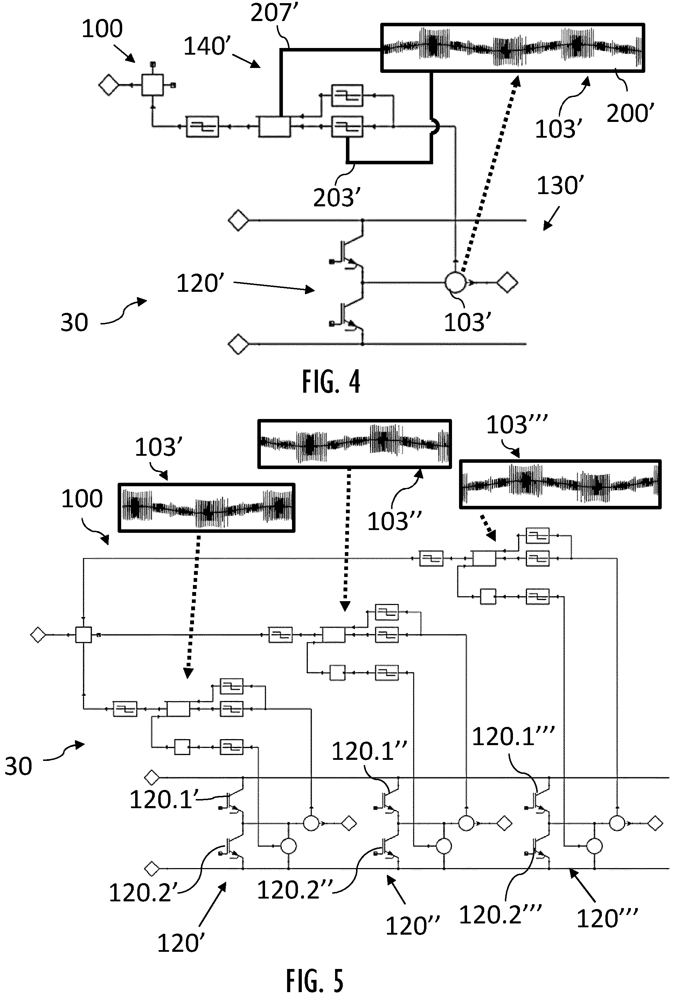

Referring now to Figure 4, which illustrates the frequency converter 100 according to an embodiment. The frequency converter 100 is configured to utilize the state of the current for defining the threshold of the allowable state of current in response to the state of current 103' and/or defining the time window in response to the state of current, and wherein the state of current being configured to be formed over the time window. So, in other words, defining the threshold and/or time window may be conducted without an information on a state of voltage.

In Figure 4, the block 200' illustrates a state of current that may be a measured current of the semiconductor switch 120'. So, the measured current may be an output current of the phase that may be utilized in the operation block 147' comprising an integrator configured to integrate the state of current 103'. In other words, the state of current may be utilized in deducing the time window utilized in the integrator 147'. Alternatively or in addition, the state of current may be utilized in deducing the threshold of the allowable state of current, in block 143'.

As illustrated in Figure 4, in case the time window obtained in response of the fundamental current, the method and/or the frequency converter 100 may not need to conduct voltage measurement/s of the at least one semiconductor switch in order to obtain the time window to be used. It may be possible, though, that voltage measurement/s of the at least one semiconductor switch is/are performed for other purposes. It may be possible that for the time window conduction both fundamental current and the output voltage is needed. Namely, there may be done a comparison to check which time window suggestions in response to the fundamental current or output voltage. Assuming now that the time window based on the fundamental current has a value "a" and the time window based on the output voltage has a value "b", then there can be a comparison between the values "a" and "b". Then, the time window may be, for example, maximum, i.e., max("a","b") or average of "a" and "b", i.e. (a+b)/2, or minimum min("a","b").

In other words, the embodiment of Figure 4 relates to the frequency converter 100, configured to be connected with an electric machine 50 via a cable 40 connecting them electrically together, for detecting an operational deviation therein. The frequency converter 100 comprises a monitoring circuitry 130', 130", 130‴ configured to monitor an electric state within the operation controller 30 and/or between the operation controller 30 and the electric machine 50. The electric state comprises at least a state of current. The frequency converter 100 further comprises at least one processing circuitry 140' that defines a time window in response to the state of current, and wherein the state of current is formed over the time window, and the processing circuitry 140' comprises a threshold 110, 110.1, 110.2 of an allowable state of current available. Alternatively or in addition, the frequency converter 100 further comprises at least one processing circuitry 140' that defines a threshold 110, 110.1, 110.2 of an allowable state of current in response to the state of current. The frequency converter 100 further comprises a first comparator 132' configured to compare the state of current with the threshold 110, 110.1, 110.2 of the allowable state of current.

As can be seen, Figure 4 may refer to an illustration of only one phase of the 3-phase, 2-level inverter. Line 207' depicts in Figure 4 that information related to the state of current is utilized in defining the time window and line 203' illustrates that information related to the state of current is utilized in defining the threshold of the allowable state of current.

Figure 5 illustrates an embodiment, wherein the electric state comprising at least a state of current is utilized in defining the time window and/or threshold of an allowable state of current. As can be seen, each phase may have different states of current 103', 103", 103‴, and it may be possible to detect in which phases the operational deviation happens. As can be seen, alternatively or in addition, the time window may be defined in response to the electric state comprising the state of voltage. So, in other words, time window may be defined in response to the state of voltage. Figure 5 illustrates monitoring of voltages that may be called as phase voltages or phase voltage states. It is possible that phases may utilize different strategies to monitor the electric state, for example, one phase utilizes output phase voltage for defining the time window and a second phase utilizes output current of the phase for defining the time window, and a third phase utilizes output current of the phase to define the threshold utilized in the corresponding phase. It may be possible that the voltage state of other phases may be utilized in one phase. In other words, state change in phase 2 could be used to change the time window of other phases (1 and 3) maybe in different manner than in phase 2. As can be seen phases may have deterministic phase shift with respect to each other. The deterministic phase shift may be a constant phase shift. In three-phase systems, the phase shift may be commonly 120 degrees.

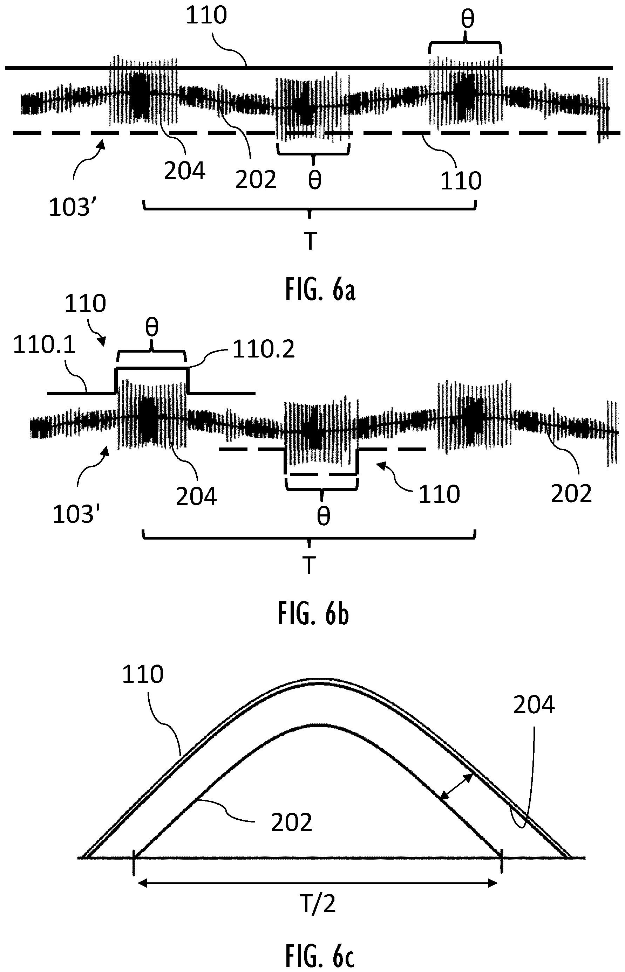

Referring now to Figure 6a that illustrates a current measurement for a one phase, i.e. monitoring of the electric state comprising a state of current. The state of current may comprise measured current within the operation controller 30 such as the semiconductor switch. The measured current 103', that is an alternating current, as illustrated in Figure 6a may comprise a fundamental current 202 and high frequency components 204. The fundamental current 202 may be obtained by filtering the measured current. In other words, the state of current may be filtered to obtain the fundamental current 202. According to an embodiment, the second time window is utilized during around the peaks of the fundamental current and the first time window is utilized outside of the peaks of the fundamental current. In Figure 6a, the symbol "T" represents a period of the frequency. The area "around the peak of the fundamental current" may be defined to be about 60deg as depicted with a symbol θ. As can be seen from Figure 6a, there may be exceedances (fundamental current + high frequency components) of the threshold of the allowable state of current around the peak of the fundamental current.

Peaks of the fundamental current may refer to positive peaks and/or negative peaks as the threshold may be positive and/or negative, respectively.

According to an embodiment, the method comprises a step in which the second time window is utilized during around the peaks of the fundamental current when the change of the electric state is detected therein, and the first time window is utilized outside of the peaks of the fundamental current. In other words, it is possible to change the time window only after state change around the fundamental current peak. In case the state change happens during the peak of the fundamental current, then the time window may be changed, for example from the first time window to the second time window.

The method renders it possible to change the time window always around the peaks of the fundamental current or after the change of the electric state is detected around the fundamental current.

According to an embodiment, the threshold 110 is defined in response to the fundamental current 202. It can be also seen the high frequency components 204 which are on top of the fundamental current 202. High frequency components may have a greater variance around the peak of the fundamental current. Variance of high frequency components may depend on a modulation method. Even though, Figure 6a illustrates that the threshold 110 defined in response to the fundamental current 202 is constant, the threshold may vary in response to the fundamental current. The threshold 110 shown with solid line refers to threshold of positive going current. So, the threshold 110 with the solid line may refer to positive threshold. The threshold 110 with the dashed line refers to negative going current. So, the threshold with the dashed line 110 may refer to negative threshold. The negative threshold is on the negative axis side. The positive threshold is on the positive axis side.

Referring now to Figure 6b disclosing an embodiment of defining the threshold in response to the state of current. According to an embodiment of the invention the frequency converter 100 is configured to utilize a higher threshold 110.2 around a peak of the state of current 103' during a period T of current and a lower threshold 110.1 outside of the peak of the current signal during a period of current. The state of current may refer to the fundamental current. In other words, the threshold may comprise a first part and a second part. The first part may have different values than the second part. According to an embodiment, the first part has greater values than the second part. Figure 6b illustrates a stepwise function for the threshold, but in practice a shape of a threshold curve may vary. In other words, if the threshold of the allowable state of current represents the overcurrent threshold, the threshold may be defined in response to the magnitude of the fundamental current such that around the peak of fundamental current, say during 60 deg, the overcurrent threshold 110 is higher and otherwise the overcurrent threshold 110 is lower. By symbol θ it is illustrated the angle around the peak of the fundamental current during which the overcurrent threshold is higher. The threshold 110 shown with solid line refers to threshold of positive going current. The threshold 110 with dashed line refers to negative going current, i.e. negative threshold. The negative threshold is on the negative axis side. The positive threshold is on the positive axis side.

Referring now to Figure 6c, according to an embodiment, the frequency converter 100 is configured to adjust the threshold of the allowable state of current substantially continuously to match a curve formed of the alternating current added with a buffer zone. Figure 6c illustrates a half period T/2 of the fundamental current 202, the fundamental current + high frequency components 204 and the threshold 110 above the fundamental current + high frequency components. The fundamental current may be obtained and/or recovered by a filtering, or other means, for example, model-based estimation in the control software. In Figure 6c it is illustrated the threshold 110 for positive going current (positive threshold). It is possible to have also a negative threshold for negative going current. In other words, threshold curve on the negative axis side.

So referring to embodiments of Figures 6a, 6b and/or 6c, the frequency converter 100 utilizes a higher threshold around a peak of the state of current during a period of a current. The frequency converter utilizes a lower threshold outside of the peak of the current signal during a period of a current. Alternatively or in addition, the frequency converter adjusts the threshold of the allowable state of current substantially continuously to match a curve formed of the alternating current added with a buffer zone.

Referring to Figures 2-5 and/or 6a, 6b and/or 6c. According to an embodiment, the frequency converter comprises instructions to control operation of the operation controller in response to a comparison of the state of current to the threshold of the allowable state of current. For example, if after comparison in the first comparator, the state of current with the threshold of the allowable state of current indicates difference and/or operational deviation such as an overcurrent event and/or short-circuit event, then the frequency converter may shut down the switches for preventing their damage.

Referring now to Figures 1-5, another aspect of the invention according to an embodiment is a system for detecting an operational deviation comprising a frequency converter 100 comprising an operation controller 30 connected electrically together via a cable 40 with an electric machine 50. In other words, the aspect of the invention may refer to the electric machine operation controller system 1000 for detecting an operational deviation comprising a frequency converter 100 connected electrically together with an electric machine 50via a cable 40. Thus, it renders possible to detect operational deviations within the system and act accordingly, for example with preventing actions.

According to an embodiment, the electric machine 50 comprises a motor or a generator.

Another aspect of the invention relates to a method of detecting an operational deviation.

Referring to embodiments of Figures 1-5 and 6a, 6b and 6c and 7, the method of detecting an operational deviation in a system 1000 comprises a frequency converter 100 comprising an operation controller 30 connected electrically together via a cable 40 with an electric machine 50. The method comprises the steps of monitoring, by a monitoring circuitry 130', 130", 130‴, an electric state within the operation controller 30 and/or between the operation controller 30 and the electric machine 50. The electric state comprises at least a state of current 103', 103", 103‴. The method comprises at least one of the following steps: step A and/or step B. Step A comprises defining a time window, by at least one processing circuitry 140', 140", 140‴, in response to the electric state; and wherein the state of current 103', 103", 103‴ is formed over the time window within the operation controller 30 and/or between the operation controller 30 and the electric machine 50, a threshold 110, 110.1, 110.2 of an allowable state of current being available for the processing circuitry 140', 140", 140‴. Step B comprises defining a threshold 110, 110.1, 110.2 of an allowable state of current in response to the state of current 103', 103", 103‴. The method further comprises a step of comparing by a first comparator 132', 132", 132‴ the state of current 103', 103", 103‴ to the threshold 110, 110.1, 110.2 of the allowable state of current. Advantageously, the method renders it possible to vary the time window and/or the threshold of the allowable state of current so as to detect the operational deviation.

In other words, the method of detecting an operational deviation in a system 1000 comprises a frequency converter 100 connected electrically together with an electric machine 50 by a cable 40. The method may comprise the steps of: monitoring, by a monitoring circuitry 130', 130", 130‴, an electric state within the operation controller 30 and/or between the operation controller 30 and the electric machine 50. The electric state comprises at least a state of current 103', 103", 103‴. The method comprises a step comprising: defining a time window, by at least one processing circuitry 140', 140", 140‴, in response to the electric state; and wherein the state of current 103', 103", 103‴ is formed over the time window within the operation controller 30 and/or between the operation controller 30 and the electric machine 50. A threshold of an allowable state of current being available for the processing circuitry 140', 140", 140‴. The method further comprises a step of comparing by a first comparator 132', 132", 132‴ the state of current 103', 103", 103‴ to the threshold 110, 110.1, 110.2 of the allowable state of current. The method of detecting an operational deviation in a system 1000 comprises a frequency converter 100 connected electrically together with an electric machine 50 by a cable 40. The method may comprise a step comprising defining a threshold 110, 110.1, 110.2 of an allowable state of current in response to the state of current 103', 103", 103‴. The method further comprises a step of comparing by a first comparator 132', 132", 132‴ the state of current 103', 103", 103‴ to the threshold 110, 110.1, 110.2 of the allowable state of current.

As mentioned earlier, the operation controller may be considered to be part of the frequency converter, then in other words, the invention may relate to the method of detecting an operational deviation in a system comprising a frequency converter connected with an electric machine.

According to an embodiment of the method, in the step A, the electric state comprises a state of voltage within the operation controller and/or between the operation controller and the electric machine for defining the time window.

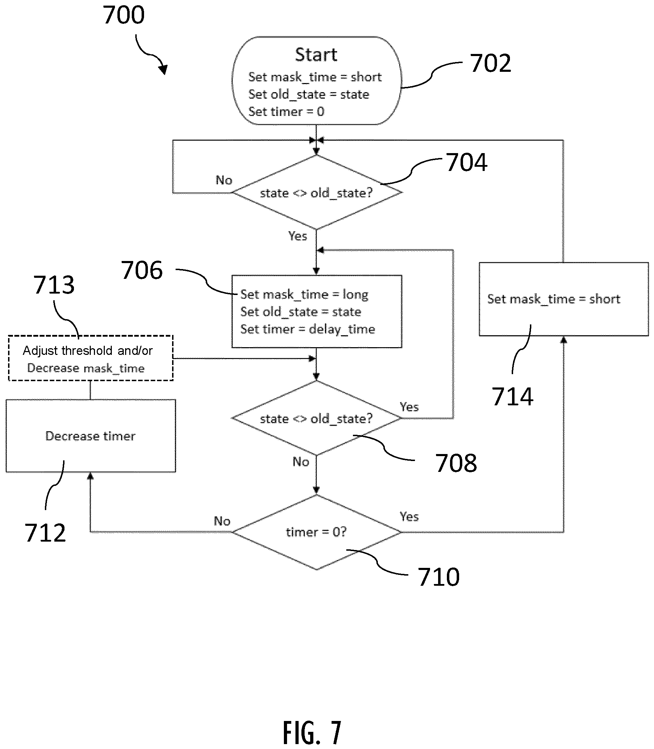

So, examine in detail embodiment steps referring to the method disclosed in Figure 7. Referring now to a case wherein the electric state comprises the state of voltage. A basic principle may be considered so that that for each change in output phase voltage state, the short circuit time window (i.e., masking time) may be changed to a predefined value for a predefined time.

The method comprises a step, according to an embodiment, wherein after the first time period, in case the state of the voltage signal remains at the second state, the second time window is changed from the second time window to the first time window. In other words, in reference to Figure 7, after the time is elapsed and the state of voltage remains at the same state, the time window (may also be called as a masking time) may be returned, for example, to its initial value. The initial time window (i.e., masking time) may be called as "short" and the time window (i.e., masking time) after the state change and during (current) transient/oscillation is "long". For example, when ringing (oscillation) is present, then masking time may be long, like 4 µs. The time how long the masking time change is effective may be called as "delay_time". In other words, the "delay_time" may be the time period during which prolonged masking time is applied. The longer masking time may be held for longer time than the actual masking time is. For example, if short mask time is 1 µs and long is 2 µs, the delay might still be 5 µs so the long masking time is used for 5 µs after a state transition.

The diagram 700 discloses steps of the method according to an embodiment. So, during the first block 702, values for the time window (mask_time), the state of the voltage (old_state) and the first time period (set timer) are set and/or monitored. Those values may be a pre-defined values based on experience in connection with the system and its components.

According to an embodiment, the time window comprises a preset initial time window value. In the diagram 700, the preset initial time window value is depicted with "set mask_time" and it is referred to as "short" in the block 702. The preset initial time window value may be within a range of about 0 µs to about 5 µs. Choosing the initial time window value to be 1 µs according to an embodiment, so as to illustrate the steps in Figure 7. Then "set mask_time = 1 µs" in the first block 702. The initial time window may also refer to a first time window in this description.

According to an embodiment, the method comprises a preset state of voltage. The preset state of voltage may comprise voltage monitored within the operation controller and/or between the operation controller and the electric machine. The preset state of voltage may comprise voltage monitored in a corresponding phase. At first the diagram sets an old state (old_state) as "state". In other words, the old state may be formatted to be the preset state of voltage during the beginning.

The state of voltage is referred in Figure 7 as "state". In other words, during the block 704 "state <> old_state", the state of voltage is compared to the old state. In other words, in case the old state may be formatted to be the preset state of voltage, during the beginning, the present state of voltage is compared to the preset state of voltage. In the diagram, symbol "<>" refers to the inequality symbol ≠. So, in case, the state of the measured output voltage of the at least one power semiconductor switch differs from the earlier state (e.g. from old_state or preset state of voltage), then one follows the route "yes" to the next block 706.

According to an embodiment of the method, in case of a state of voltage changes from a first state to a second state, the time window is changed from a first time window to a second time window for a first time period in the step A. So, the block 706 depicts "set mask_time=long", "set old_state = state" and "set timer = delay_time". In the block 706 values for the time window, the state and the first time period are set. So, there has been a state change in the voltage (i.e, in the previous block state <> old_state or in other symbol state ≠ old_state). Assuming that now time window is changed from the first time window (1 µs) to the second time window. Assuming that the second time window is 4 µs. Thus, in the block, set mask_time = 4 µs.

According to an embodiment, the first time period is a constant value. In other words, how long the time window is changed to the second time window may be constant. The first time period may be called as a delay time. The constant value (the first time period) may be selected by an estimated worst case cable oscillation, or it may be dependent on a user parameter (that may be set during commissioning) or based on estimated/measured cable length/type or user can also enter cable length and/or type which is then used to calculate the period.

The first time period may be longer than the second time window. Referring still to Figure 7, assuming that the first time period is chosen as 16 µs. So, in other words, the delay time refers to the first time period. Thus, "set timer = delay_time = 16 µs" in block 706. In practice, the delay time, i.e. the first time period, how long the time window (masking time) is changed may be a constant value selected by an estimated worst case cable oscillation, or it may be dependent on user parameter (that may be set during commissioning) or based on estimated/measured cable length/type or user can also enter cable length and/or type which is then used to calculate the period.

Block 706 sets the mask time used in the detection and the period to apply that mask time, and then continues to block 708. So, the state of voltage is compared to the old state (state <> old_state) in block 708. It should be noted that the mask time is set by the state machine and the overcurrent detection may be independent of the state machine operation. The state machine may have a pre-defined clock rate which, in other terms, may define a resolution on how quickly the changes in the state of voltage may be detected. The state of voltage may be compared to the old state substantially continuously (or at a very high rate) and may be independent of the mask time and delay time as itself. For example, the state machine may run every 100 ns (and thus may differ, for example, from the mask time). In practice the state machine may run at a fixed rate, e.g. every 100 ns. In other words, this means that the comparison of the state of voltage, in block 708, may be conducted every 100 ns.

Assuming that state has not changed, in block 708, then the algorithm checks whether timer is zero (timer = 0?) in block 710. In case the timer is not zero, the route "no" is taken in the diagram. Then the block 712, i.e., "decrease timer", decreases the first time period by 100 ns that is a frequency of the time machine. In block 713 the threshold may be adjusted (changed, increased and/or decreased) and/or mask time (i.e., time window) may be decreased. Then the state of voltage may be checked in block 708. So, in case the state of the measured output voltage remains unchanged, the loop (to check the state 708 and timer 710) via the "decrease timer" (712) and optionally also adjust threshold and/or decrease mask time (713) goes until timer = 0. When the timer is 0, the mask time (i.e., time window) is set to "short", in block 714. Then the state of voltage will be checked in the block 704. For example, in this example, to 1 µs. In other words, the time window may be changed to the preset initial time window value after the first time period. So, according to an embodiment, the method comprises a step wherein after the first time period, in case the state of voltage remains at the second state, the second time window is changed from the second time window to the first time window. So, it may possible, that the second time window is changed to the first time window, in other words to a time window that was before the change to the second time window. It may be possible, that the second time window is changed to the initial time window.

If another state transition (state change) happens (block 708), the "long" mask time is kept on and timer restarted (return to block 706). However, if no state transitions (state changes) happened ("yes" in 710, as it is looped through 708, 710 and 712 and optionally also 713), the mask time is returned to the "short" value 714 and then it is returned to wait for the next state transition in block 704. During the delay time (e.g. 16 µs) the masking time can be 4 µs so any overcurrent event continuing over this 4 µs causes a trip. As discussed above, the state machine might run e.g. every 100 ns and does the state change comparison at that time level. Any loops 708, 710, 712 (and optionally also 713) are run at those time steps. In other words, the looping 708, 710, 712 (and optionally also 713) may be conducted according to the frequency of the time machine (e.g., 100 ns). The mask time may be only an output signal that may be continuously output for the overcurrent detection block, and only the signal value might change in the relevant blocks. So, applying the mask time (whole overcurrent detection) may be independent of the flow in the state graph.

According to an embodiment, the method comprises a step wherein after the first time period, in case the state of the measured voltage remains at the second state, the second time window is narrowed. It may possible, that the second time window is changed back to the time window that was before the change to the second time window. It may be possible, that the second time window is changed back to the initial time window. In other words, when in the block 708 it is noticed that state is not changed and the block 710 checks that timer = 0, then one may set in the block 714 the mask time to be "short".

According to an embodiment, in case the state changes from a first state to a second state, the time window is broadened to a second time window for a first time period in the step A. According to an embodiment, in case of the state of voltage of the at least one power semiconductor switch changes from a first state to a second state, the time window is broadened to a second time window for a first time period in the step A.

If, the state of voltage is compared to the old state (state <> old_state) in the block 708 and difference is noticed (i.e., state is changed, "yes route" from the block 708), then mask_time (i.e. time window) is kept long, old_state is set as state and timer is set to delay_time (i.e., first time period) in block 706.

According to an embodiment, the method comprises a step during the first time period to adjust threshold. In other words, the threshold may be changed during the first time period. The threshold adjustment may be done substantially at the same time or after the step of decreasing timer (of the time period). The term "adjust" may be understood broadly and it may be possible that the term "adjust" comprises a comparison and/or checking step in which the threshold value is checked whether it is at a desired level. It may be possible to gradually decrease the threshold.

According to an embodiment, the method comprises a step during the first time period to decrease time window. In other words, the masking time may be changed, for example, decreased, during the first time period. The time window may be decreased substantially at the same time or after the step of decreasing timer (of the time period). It may be possible to gradually decrease the time window (masking time).

As illustrated in Figure 7, there may be an optional step to adjust and/or decrease the masking time in the block 713 according to an embodiment. In other words, the method may loop via the blocks 708, 710 and 712 or the method may loop via the block 708, 710, 712 and 713 during the delay time (i.e., the first time period) in case the state remains the same. The timer for the delay time is shortened in the block 712. It should be noted that there may be loops in which the time window (masking time) and/or threshold may not be changed in the block 713. This means that the block 713 may be bypassed in looping during the delay time.

Referring to above example after the first time through the blocks of 708, 710, and 712 when decreasing the timer, after the block 712, i.e. in the block 713 a new threshold value may be set. Alternatively or in addition, after the first time through the blocks of 708, 710, and 712 when decreasing the timer, after the block 712, i.e. in the block 713, the time window may be decreased. In other words, the masking time may be decreased during the first time period. It should be noted that that, even though, block 713 has been drawn as a separate step from the block 712, it may be possible that adjusting the threshold and/or decreasing the masking time may be conducted substantially simultaneously with the decreasing the timer step (in block 712). In other words, it may be possible that instead of assigning another 4 µs for masking time, it may be possible that in the block 712, the masking time (time window) is decreased to 3 µs and/or the threshold may be decreased. Then again, in case there is no state change, the time window may be decreased to 2 µs and/or the threshold may be decreased. This may be looped (blocks 708, 710, 712 and 713) accordingly until the timer is zero. In real cases, during transient ringing, 4 µs may be long enough for current waveform peaks to decay to amplitudes lower than the set threshold value. Therefore, the time window (masking time) from 4 µs may be decreased as well as the threshold may be decreased.

As noted above, the Figure 7 was disclosed in view of an embodiment wherein the electric state comprises the state of voltage. It should be noted, however, that it may be possible to utilize the state of current in defining the time window. When checking the states (current state vs. old state), state < > old_state, the state of current may refer to checking whether, state is around the peak of the current, i.e., around the peak of the fundamental current.

According to an embodiment, the method comprises a step wherein after the first time period, in case the state of voltage remains at the second state, the second time window is broadened.

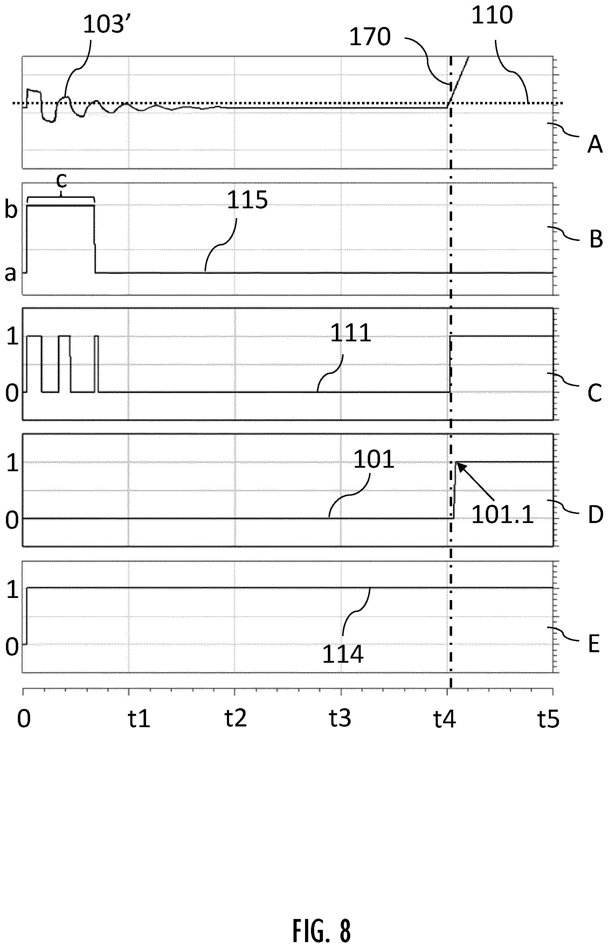

Referring now to Figure 8 that illustrates wave forms according to an example of an embodiment of the invention.

According to an embodiment the method comprises a step wherein the state of current comprises at least one of the following an alternating current monitored within the operation controller and/or between the operation controller and the electric machine or current polarity within the operation controller and/or between the operation controller and the electric machine.

In Figure 8, horizontal axis refers to time axis, see schematic time instances t1, t2, t3, t4 and t5. The first row A illustrates output current values 103' of one power semiconductor switch 120', i.e. for a one phase. In other words, Figure 8 illustrates schematic events for a one phase system. It should be understood that corresponding data (but potentially different looking curves/data), can be obtained from other phases too. The unit in vertical axis in the first row A is in amperes [A]. The first row A illustrates also a threshold 110 for an overcurrent event. The threshold may be a positive threshold in this case. The second row B illustrates, the time window (mask time) 115 and the unit in vertical axis in in microseconds [µs]. The preset initial time window value is set at the level a, for example, a = 1 µs and during oscillation the second time window b is 4 µs. The first time period c may be, for example, 16 µs. So, after oscillation, the second time window is set back to the level a, i.e. in this example to 1 µs. The third row C illustrates simulated actual events 111, based on the first row A, whether the current exceeds the threshold values or not. As illustrated, the curve of the events 111 in the third row gets values 0 meaning that there is no exceedance of the overcurrent threshold or 1 meaning an exceedance of the overcurrent threshold. The fourth row D illustrates overcurrent events 101 indicated by the method according to the invention with the defined time windows 115 based on the state of the measured output voltage 106' of the power semiconductor switch 120' according to an embodiment of the invention. As illustrated curve of the overcurrent events 101 of the method in the fourth row gets values 0 or 1. The fifth row E illustrates the state 114 of the measured output voltage of the power semiconductor switch. As illustrated in the fifth row, the state 114 of voltage gets values 0 or 1.

As can be seen from the fifth row E in the figure 8, that there is only one state change for voltage. During the beginning the state value 114 jumps from 0 to 1. In other words, the state of voltage changes. So, after the state changes, the current starts to oscillate. The oscillation of current 103' occurs between the time interval from 0 to t2. This phenomenon is shown in the first row A. During the oscillation, there are three exceedances of the output current to the overcurrent threshold during the time interval from 0 to t1. Transient/ringing current (i.e., oscillation) is of decaying type meaning that peak values get smaller every ringing period. Fourth peak and the latter peaks are below the overcurrent threshold. However, it may not be practical to trip the circuit (shut down the semiconductor switch) during such an oscillation (i.e., during exceedance of threshold by current during oscillation). Thus, according to an embodiment of the invention, the time window is changed for a longer time window based on the state change of voltage (as discussed in connection with Figure 7), i.e. during at least on a beginning of the oscillation, and shown in the fourth row D. Thus, there will be no nuisance overcurrent tripping during the beginning oscillation within the time interval from 0 to t1 since the curve of the overcurrent events 101 remains 0 on that interval. In other words, due to the utilized time window (i.e., the second time window), the currents do not cause the switch to trip. So, the time window is broadened for the first time period, i.e. to time interval, so that the (cable) oscillation is attenuated enough after which the time window may be decreased back to its original value, for example to the preset initial time window. Because of utilizing decreased (narrower) time window after higher oscillations, it provides faster overcurrent detection.

According to an embodiment, the method comprises a step wherein the second time window is utilized around a peak of the fundamental current and the first time window outside of the peak of the fundamental current.

In Figure 8, a vertical dash-dot line 170 illustrates a short circuit event that is when the output current exceeds the overcurrent threshold (cf. also illustrated in the curve of actual events 111). Due to the short time window (see curve 115 set after the oscillation, the level of time window is at a), the short circuit event (overcurrent threshold) can be seen quickly when the overcurrent event curve 101 gets the value 1 as marked with an arrow 101.1.

Advantageously, a selection of the time window is based on the state of voltage 106', 106", 106‴ of the at least one power semiconductor switch 120', 120", 120‴, 120.1', 120.2', 120.1", 120.2", 120.1‴, 120.2‴. In other words, in case the state of voltage of the at least one power semiconductor switch changes, the time window may be changed. Thus, it may be possible to increase the time window during current oscillation period which means that during oscillation overcurrent events do not effect on turning off the switch. In other words, during oscillation overcurrent events are considered to be "blind" in the system. Thus, the time window may be called as a masking time. Short exceedances of the overcurrent threshold, during oscillation, do not trigger the overcurrent event and thus components may be operated according to a normal operational mode (the semiconductor switch may be operated according to normal mode instructions).

Referring now back to embodiment in Figure 6b, in step B of the method, the state of current comprises an alternating current and wherein a higher threshold of the allowable state of current is utilized around a peak of alternating current during a period of a current and a lower threshold outside of the peak of the current during a period of a current.

According to an embodiment, in the step B, higher overcurrent threshold is utilized around a peak of the fundamental current and lower overcurrent threshold outside of the peak of the fundamental current. In other words, the overcurrent threshold comprises at least two threshold values: a first overcurrent threshold within the peak of the fundamental current and a second overcurrent threshold outside of the peak of the fundamental current. It should be understood that term "around the peak of the fundamental current" may comprise a peak area of the fundamental current. In other words, around the peak of the fundamental current may not mean only the very highest peak value of the fundamental current but values at a vicinity of the peak of fundamental current.

According to an embodiment of the method, around the peak of the current is 60deg of the half period.

In the embodiment of Figure 6c, in step B of the method, the threshold of the allowable state of current is adjusted substantially continuously to match a curve formed of the alternating current added with a buffer zone. This means that for current is added a positive value to form the buffer zone. For example, in case current is depicted with a symbol I_{fund} and a positive buffer constant depicted with a symbol a_{buff}, then the threshold, depicted with a symbol I_{th,buff} may be of the form I_{th,buff} = I_{fund}+ a_{buff}. The buffer zone may comprise high frequency components.

So, in accordance with an embodiment in step B of the method, the state of current comprises an alternating current and wherein a higher threshold of the allowable state of current is utilized around a peak of alternating current during a period of a current and a lower threshold outside of the peak of the current during a period of a current or the threshold of the allowable state of current is adjusted substantially continuously to match a curve formed of the alternating current added with a buffer zone. Therefore, there is not necessarily need to change and/or utilize time window, or the time window may be kept constant.

According to another aspect, the invention relates also to a computer readable medium comprising program instructions for causing a computing apparatus to carry out a method of detecting an operational deviation in a system comprising a frequency converter comprising an operation controller connected with an electric machine by a cable. In other words, detecting an operational deviation may be implemented with a computer program according to an embodiment by utilizing monitoring of electric state. Comparators and/or integrators may be implemented with a computer program. Monitoring of electric state may be conducted with voltage and/or current measurements as discussed above.

According to an embodiment, in case of the state of voltage of the at least one power semiconductor switch changes from a first state to a second state, the time window is changed to a second time window for a first time period in the step A.

According to an embodiment, the method comprises both steps A and B for changing the threshold and time window.

According to an embodiment, the threshold is higher after a state change of the state of voltage.

According to an embodiment, the frequency converter 100 is configured to detect a change of a state of the voltage from a first state to a second state, and after detecting the change to change the time window to a second time window for a first time period.

According to an embodiment, the frequency converter 100 is configured to detect a change of a state of the voltage from a first state to a second state, and after detecting the change to broaden the time window to a second time window for a first time period.

According to an embodiment, in case of the state of voltage changes from a first state to a second state, the time window is narrowed to a second time window for a first time period in the step A. This may help to detect short-circuit events quickly and accurately. According to an embodiment, in case of the state of voltage of the at least one power semiconductor switch changes from a first state to a second state, the time window is narrowed to a second time window for a first time period in the step A.

According to an embodiment, the frequency converter 100 is configured to detect a change of a state of voltage from a first state to a second state, and after detecting the change to narrow the time window to a second time window for a first time period.

According to an embodiment, the frequency converter 100 is configured to change the second time window after the first time period in case the state of the measured voltage remains at the second state.

According to an embodiment, the frequency converter 100 is configured to change the second time window to the initial time window after the first time period in case the state of voltage remains at the second state.

According to an embodiment, the frequency converter 100 is configured to narrow the second time window after the first time period in case the state of voltage remains at the second state.

According to an embodiment, the frequency converter 100 is configured to utilize a higher threshold around a peak of the fundamental current and lower threshold outside of the peak of the fundamental current.

According to an embodiment, the method comprises a step in which one phase is switched off, the current either returns through remaining phases, or through earth connection so bypassing the remaining phases. In case of a 3-phase, 2-level inverter, when one phase is switched off, the current may either return through the two remaining phases, or through earth connection so bypassing the two remaining phases.

According to an embodiment, the second time window is applied only to a phase in which the state of voltage changes. In other words, the time window may be changed to the second time window in the phase in which the state of the voltage changes. The second time window may be broader than the time window utilized earlier.

According to an embodiment, the second time window is applied to all of the phases whenever one of the phase output voltages changes the state. In other words, the time window may be changed to the second time window in all of the phases in case the state of the voltage changes in one of the phases.

According to an embodiment, the method comprises a step wherein the broader time window is utilized around a peak of the fundamental current and the narrower time window outside of the peak of the fundamental current.

According to an embodiment the method comprises a step wherein the broader time window is utilized in case the electric state changes around the peak of the fundamental current. In other words, in case the change of the electric state takes place around the peak of the fundamental current, the time window may be changed. The second time window may be utilized in case the electric state changes around the peak of the fundamental current.

According to an embodiment, the method comprises a step wherein around the peak of the fundamental current is defined as 60deg of the half period.

According to an embodiment, the method comprises a step wherein the overcurrent threshold is adjusted substantially continuously to match the output fundamental current magnitude comprising a buffer zone.

According to an embodiment, in the step A of the method, the time window comprises a preset initial time window value. The preset initial time window selection may be a table value, value deduced and/or decided in advance or based on a measurement of the system.

According to an embodiment, the monitoring circuitry comprises measuring circuitry. The measuring circuitry may be used to monitor the electric state of within the operation controller 30 and/or between the operation controller 30 and the electric machine 50.

According to an embodiment, the semiconductor switch is an IGBT. Thus, the semiconductor switch may comprise a gate, a collector and an emitter.

According to an embodiment, the semiconductor switch is a MOSFET. Thus, the semiconductor switch may comprise a gate, a source and a drain.

According to an embodiment, the semiconductor switch is part of a frequency converter.

Embodiments of the method, frequency converter and system are not limited to only IGBT and MOSFET type switches but can be applied also to other types of power semiconductor switches.

Even though the embodiments in Figures 2-5 related specifically to monitor an electric state within the operation controller, it is possible, additionally or alternatively, to monitor an electric state between the operation controller and the electric machine.

Since embodiments are suitable for detecting overcurrent events, it may be possible to use terms a frequency converter for detecting an overcurrent event, the system for detecting an overcurrent event and a method of detecting an overcurrent event in this description.

In this description same reference numerals have been used throughout the figures, and thus different embodiments may be combined in practical circumstances as understood by a person skilled in the art.

It will be obvious to a person skilled in the art that, as technology advances, the inventive concept can be implemented in various ways. The invention and its embodiments are not limited to the example embodiments described above but may vary within the scope of the claims.

## Claims

1. A frequency converter comprising an operation controller, configured to be connected electrically via a cable together with an electric machine, for detecting an operational deviation therein comprising:
a monitoring circuitry configured to monitor an electric state within the operation controller and/or between the operation controller and the electric machine and wherein the electric state comprises at least a state of current;
wherein the frequency converter further comprises at least one processing circuitry configured to:
a. define a time window in response to the electric state, and wherein the state of current being configured to be formed over the time window, and the processing circuitry comprises a threshold of an allowable state of current available; and/or
b. define a threshold of an allowable state of current in response to the state of current; and
wherein the frequency converter further comprises a first comparator configured to compare the state of current with the threshold of the allowable state of current.

2. The frequency converter of claim 1, wherein the state of current comprises at least one of the following alternating current monitored within the operation controller and/or between the operation controller and the electric machine or polarity of current within the operation controller and/or between the operation controller and the electric machine.

3. The frequency converter of claims 1 or 2, wherein the electric state comprises a state of voltage within the operation controller and/or between the operation controller and the electric machine configured to define the time window.

4. The frequency converter of claim 3, wherein the frequency converter comprises means configured to detect a change of the state of voltage from a first state to a second state within the operation controller and/or between the operation controller and the electric machine, and after detecting the change of the state, the frequency converter is configured to change the time window from a first time window to a second time window for a first time period.

5. The frequency converter of any of claims 2-4, wherein the frequency converter is configured to utilize a higher threshold around a peak of the state of current during a period of a current and a lower threshold outside of the peak of the current signal during a period of a current or the frequency converter is configured to adjust the threshold of the allowable state of current substantially continuously to match a curve formed of the alternating current added with a buffer zone.

6. The frequency converter of any of claims 1-5, wherein the frequency converter comprises instructions to control operation of the operation controller in response to a comparison of the state of current to the threshold of the allowable state of current.

7. A system for detecting an operational deviation comprising a frequency converter comprising an operation controller according to claims 1-6 connected electrically together via a cable with an electric machine.

8. The system of claim 7, wherein the electric machine comprises a motor or a generator.

9. A method of detecting an operational deviation in a system comprising a frequency converter comprising an operation controller connected electrically together via a cable with an electric machine, and wherein the method comprising the steps of:
monitoring, by a monitoring circuitry, an electric state within the operation controller and/or between the operation controller and the electric machine, wherein the electric state comprises at least a state of current;
wherein the method comprises at least one of the following steps:
Step A comprising:
defining a time window, by at least one processing circuitry, in response to the electric state; and
wherein the state of current is formed over the time window within the operation controller and/or between the operation controller and the electric machine, a threshold of an allowable state of current being available for the processing circuitry; and
Step B comprising:
defining a threshold of an allowable state of current in response to the state of current; and
wherein the method further comprises a step of comparing by a first comparator the state of current to the threshold of the allowable state of current.

10. The method of claim 9, wherein, in the step A, the electric state comprises a state of voltage within the operation controller and/or between the operation controller and the electric machine for defining the time window.

11. The method of claim 10, in case of a state of voltage changes from a first state to a second state, the time window is changed from a first time window to a second time window for a first time period in the step A.

12. The method of claim 11 comprises a step wherein after the first time period, in case the state of voltage remains at the second state, the second time window is changed from the second time window to the first time window.

13. The method of claim 9, wherein, the state of current comprises at least one of the following an alternating current monitored within the operation controller and/or between the operation controller and the electric machine or current polarity within the operation controller and/or between the operation controller and the electric machine.

14. The method of claim 9, wherein in step B, the state of current comprises an alternating current and wherein a higher threshold of the allowable state of current is utilized around a peak of alternating current during a period of a current and a lower threshold outside of the peak of the current during a period of a current or the threshold of the allowable state of current is adjusted substantially continuously to match a curve formed of the alternating current added with a buffer zone.

15. A computer readable medium comprising program instructions for causing a computing apparatus to carry out a method of detecting an operational deviation in a system comprising a frequency converter comprising an operation controller connected with an electric machine by a cable according to any one of the claims 9-14.
